Europäisches Patentamt

European Patent Office

Office européen des brevets

(19)

(11) Veröffentlichungsnummer: **0 194 570**

**A2**

(12) **EUROPÄISCHE PATENTANMELDUNG**

(21) Anmeldenummer: 86102892.6

(22) Anmeldetag: 05.03.86

(51) Int. Cl.⁴: **H01J 37/153** , H01J 37/04

(30) Priorität: 11.03.85 DE 3508609

(43) Veröffentlichungstag der Anmeldung:
17.09.86 Patentblatt 86/38

(84) Benannte Vertragsstaaten:
DE FR GB IT NL

(71) Anmelder: **Siemens Aktiengesellschaft Berlin und München**
**Wittelsbacherplatz 2**
**D-8000 München 2(DE)**

(72) Erfinder: **Frosien, Jürgen, Dr.-Ing.**
**An der Ottosäule 18**
**D-8012 Ottobrunn(DE)**
Erfinder: **Spehr, Rainer, Dr.**
**Erfurter Strasse 19**
**D-6106 Ober-Ramstadt(DE)**

(54) **Raster-Korpuskularmikroskop mit verringertem Boersch-Effekt.**

(57) Für schnelle und hochauflösende Untersuchungen an integrierten Schaltungen sind leistungsfähige Niederspannungs-Raster-Korpuskularmikroskope erforderlich. Mit den bisher auf diesem Gebiet eingesetzten konventionellen Raster-Körpuskularmikroskopen lassen sich · aber genügend feine Korpuskularsonden nicht herstellen, da die elektromagnetische Wechselwirkung zwischen den geladenen Korpuskeln der Bündelung des Strahles, insbesondere bei niedrigen Beschleunigungsspannungen, entgegenwirkt (Boersch-Effekt). Zur Reduktion der nachteiligen Einflüsse des energetischen Boersch-Effekts auf den Sondendurchmesser im Strahlerzeuger eines erfindungsgemäßen Raster-Korpuskularmikroskopes wird vorgeschlagen, die Korpuskeln den ersten Strahlüberkreuzungspunkt mit niedriger Energie durchlaufen zu lassen und sie anschließend weiter auf hohe Energien zu beschleunigen. Mit diesen hohen Energien durchlaufen die Korpuskeln dann die elektronenoptische Säule, um kurz vor Erreichen der zu untersuchenden Probe mit Hilfe einer Verzögerungseinrichtung auf die gewünschte Endenergie abgebremst zu werden. Infolge der hohen Korpuskularenergien im strahlformenden Teil der Anordnung wird zusätzlich auch der nachteilige Einfluß des lateralen Boersch-Effekts auf den Sondendurchmesser verringert.

FIG 1

| | | U | E |
|---|---|---|---|
| K | | -1 kV | 0keV |
| W | | ~ -1,5kV | |
| A1 | CR1 | +1 kV | 2keV |
| A2 | FZ | +9 kV | 10keV |
| K1 | CR2 / PE / B2 | | |
| K2 | | | 10keV |
| B3 | CR3 | | |
| D | | | |
| OB | | | |
| B4 | | 0 kV | 10keV / 1keV |
| SE / R / PR | | 0 kV | 1keV |

Raster-Korpuskularmikroskop mit verringertem Boersch-Effekt.

Die Erfindung bezieht sich auf ein Raster-Korpuskularmikroskop nach dem Oberbegriff des Anspruchs 1.

In der Halbleiterindustrie werden in allen Bereichen der Entwicklung und Herstellung mikroelektronischer Bauelemente zunehmend Raster-Elektronenmikroskope eingesetzt. So können beispielsweise einzelne Prozeßschritte zur Herstellung hochintegrierter Schaltungen kontrolliert, Masken und Wafer inspiziert oder aber Mikrostrukturen im Rahmen der Elektronenstrahl-Lithographie auf einem Objekt erzeugt werden. Im Bereich der Entwicklung setzt man Raster-Elektronenmikroskope vorwiegend zur Überprüfung der elektrischen Eigenschaften hochintegrierter Schaltungen ein. Durch Messung des zeitlichen Potentialverlaufes an ausgewählten Schaltungsknoten lassen sich Fehler im Aufbau der untersuchten Bauelemente schon während der Entwurfsphase frühzeitig erkennen und beseitigen.

Um Verfälschungen der Meßergebnisse bei quantitativen Potentialmessungen mit Raster-Elektronenmikroskopen zu vermeiden, dürfen sich die Oberflächen der auf zumeist isolierenden Trägersubstraten angeordneten Bauelemente während der Meßzeit nicht aufladen. Bei meßtechnischen Anwendungen ist deshalb darauf zu achten, daß sich der auf das Bauelement auftreffende Primärelektronenstrom und der von ihm ausgehende Strom der Sekundär-und Rückstreuelektronen nahezu kompensieren.

Diese Bedingung ist immer dann erfüllt, wenn die Primärenergie der Elektronen mit der sogenannten Neutralpunkt-Energie zusammenfällt. Diese materialabhängige Neutralpunkt-Energie ist im allgemeinen relativ niedrig und liegt typischerweise im Bereich zwischen etwa 0,5 und 2,5 keV.

Das Arbeiten mit niederenergetischen Elektronen bei meßtechnischen Anwendungen des Raster-Elektronenmikroskopes bietet zusätzlich den Vorteil, daß die Funktionsweise strahlungsempfindlicher Bauelemente -wie etwa MOS-Speichereinheiten-belastungs-und schädigungsfrei untersucht werden können.

Selbst in der Elektronenstrahl-Lithographie, wo man Mikrostrukturen zur Zeit noch mit hochenergetischen Elektronen erzeugt, wird man in Zukunft zur Verbesserung der Auflösung mit wesentlich niedrigeren Primärelektronen-Energien arbeiten müssen.

In allen Bereichen der Halbleitertechnologie besteht deshalb ein steigender Bedarf an leistungsfähigen Niederspannungs-Raster-Elektronenmikroskopen zur Durchführung von schnellen und hochauflösenden Untersuchungen an hochintegrierten Bauelementen. Da sich bei niedrigen Beschleunigungsspannungen die Auflösung und der auf der Probe zur Verfügung stehende Sondenstrom in konventionellen Raster-Elektronenmikroskopen erheblich verringert, sind diese Geräte für die genannten Aufgaben nur in begrenztem Umfang einsetzbar.

Ursache hierfür ist die Elektron-Elektron-Wechselwirkung, die einer Fokussierung des Elektronenstrahles entgegenwirkt. Besonders problematisch ist die Aufweitung des Strahles infolge des sogenannten Boersch-Effekts in Systemen, die Elektronenquellen mit hohem Richtstrahlwert besitzen (z.B. Lanthanhexaborid-Einkristallkathoden), so daß sich bei niedrigen Beschleunigungsspannungen feine Elektronensonden mit hohen Stromdichten nicht erzeugen lassen.

Der kleinstmögliche Sondendurchmesser auf einer Probe ist durch zwei grundsätzlich verschiedene Effekte begrenzt. So wächst infolge der auf dem gesamten Strahlengang wirkenden Coulomb-Abstoßung zwischen den Elektronen deren mittlerer räumlicher Abstand und damit auch der Strahldurchmesser (lateraler Boersch-Effekt). Außerdem führt die elektromagnetische Wechselwirkung zwischen den Elektronen in Bereichen hoher Stromdichten, also insbesondere in den Strahlüberkreuzungspunkten, zu einer Verbreiterung ihrer Energieverteilung, so daß sich der Sondendurchmesser indirekt über den Farbfehler der Objektivlinse zusätzlich vergrößert (energetischer Boersch-Effekt).

Ein Raster-Elektronenmikroskop mit verringertem Boersch-Effekt wurde in der deutschen Patentanmeldung P 34 29 804.5 vorgeschlagen. Nach dieser Anmeldung wird der laterale Boersch-Effekt dadurch verringert, daß man die Elektronen die elektronenoptische Säule zunächst auf hohem Potential durchlaufen läßt und sie erst kurz vor Erreichen der Probe auf die gewünschte niedrige Endenergie abbremst. Infolge der hohen Beschleunigungsspannung nimmt aber die Breite der Energieverteilung der Elektronen insbesondere im Quellen-Strahlüberkreuzungspunkt zu, so daß der verringerte Einfluß des lateralen Boersch-Effekts auf den Sondendurchmesser teilweise durch den erhöhten Beitrag des energetischen Boersch-Effekts wieder kompensiert wird.

Der Erfindung liegt deshalb die Aufgabe zugrunde, ein Raster-Elektronenmikroskop der eingangs genannten Art anzugeben, das sich durch einen im Strahlengang verringerten lateralen Boersch-Effekt und einen im Strahlerzeuger verringerten energetischen Boersch-Effekt auszeichnet. Dies wird erfindungsgemäß durch eine Anordnung nach dem kennzeichnenden Teil des Anspruchs 1 erreicht.

Der mit der Erfindung erzielbare Vorteil besteht insbesondere darin, daß auch bei niedrigen Primärelektronen-Energien der auf einer Probe verfügbare Sondenstrom bei vorgegebenem Sondendurchmesser deutlich gesteigert werden kann.

Die Ansprüche 2 bis 14 sind auf bevorzugte Ausgestaltungen und Weiterbildungen der Erfindung gerichtet.

Das erfindungsgemäße Raster-Korpuskularmikroskop wird nachfolgend anhand der Zeichnungen erläutert. Dabei zeigen

Fig.1 bis 5 erfindungsgemäße Raster-Elektronenmikroskope und

Fig.6 Elektrodenanordnungen zum elektrostatischen Abbremsen der Primärelektronen in einem erfindungsgemäßen Raster-Elektronenmikroskop.

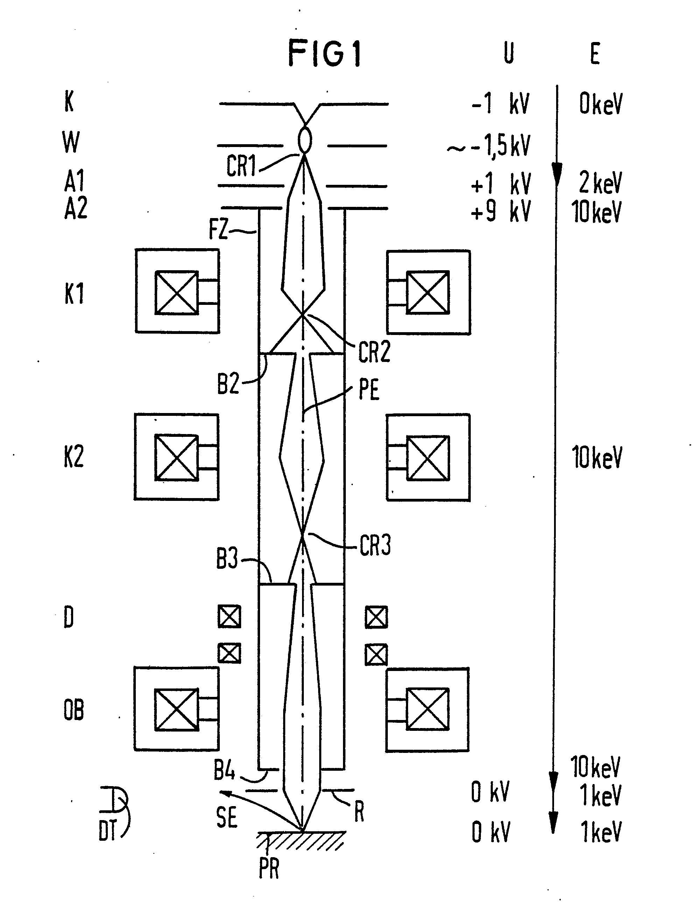

In Fig.1 ist schematisch die elektronenoptische Säule eines erfindungsgemäßen Raster-Elektronenmikroskops dargestellt. Die von der Kathode K emittierten und in Richtung der Absaugelektrode A1 und der Anode A2 beschleunigten Elektronen werden von einer Wehnelt-Elektrode W in einen ersten Strahlüberkreuzungspunkt CR1 (Quellen-crossover) fokussiert. Zur Erzeugung einer feingebündelten Elektronensonde wird dieses Quellenbild CR1 der Kathode K anschließend elektronenoptisch mit Hilfe der Kondensorlinsen K1, K2 und der Objektivlinse OB verkleinert auf eine Probe abgebildet, wobei sich die Bahnen der Elektronen nach Durchlaufen der Magnetfelder der einzelnen Linsensysteme in den Strahlüberkreuzungspunkten CR2 zw. CR3 - schneiden. Zur Verbesserung der Abbildungseigenschaften - der elektronenoptischen Einheit sind im Strahlengang Aperturblenden B2, B3, B4 eingebaut, die die auf achsenfernen Bahnen laufenden Elektronen ausblenden. Durch jede Blenden wird der auf der Probe zur Verfügung stehende Strahlstrom erheblich reduziert, so daß sich beispielsweise die Stromdichten in den Strahlüberkreuzungspunkten CR1 (Quellen-crossover) und CR3 um Größenordnungen voneinander unterscheiden. Die Positionierung des Primärelektronenstrahles PE auf einer Probe PR erfolgt mit Hilfe elektrostatischer oder magnetischer Ablenksysteme. Durch geeignete Ansteuerung der Spulenpaare des in Fig.1 dargestellten magnetischen Ablenksystems D kann der Primärelektronenstrahl zeilenförmig über eine Probe PR geführt ·oder auf einem ausgewählten Punkt positioniert werden. Zur Untersuchung eines Halbleiterbauelementes, beispielsweise einer integrierten Schaltung mittels Topographie-oder Potentialkontrast, ist das Raster-Elektronenmikroskop mit einem Detektorsystem DT zum Nachweis der auf der Probe vom Primärelektronenstrahl ausgelösten

Sekundär-oder Rückstreuelektronen SE ausgestattet. Die zur Messung von hochfrequenten Signalverläufen in integrierten Schaltungen eingebauten Komponenten eines Strahlaustastsystems sind ebenso wie die Spannungsversorgung des Strahlerzeugers und der Magnetlinsen aus Gründen der Übersichtlichkeit nicht dargestellt.

Der Bündelung eines niederenergetischen Elektronenstrahles in konventionellen Raster-Elektronenmikroskopen sind insbesondere bei Verwendung von Elektronenquellen mit hohem Richtstrahlwert enge Grenzen gesetzt. Ursache hierfür ist die auf der gesamten Strahllänge wirksame Coulomb-Wechselwirkung zwischen Elektronen, die zu einer Aufweitung der Elektronensonde führt (Boersch-Effekt). Der durch die Gleichung

$$d = (d^2_{geo} + d^2_F)^{1/2}$$

definierte Sondendurchmesser d ist abhängig von den Qua-draten des geometrischen Sondendurchmessers $d_{geo}$ und des sogenannten Farbfehlerscheibchen-Durchmessers $d_F$ . Der geometrische Sondendurchmesser $d_{geo}$ ist bestimmt durch die Aufweitung des Strahles infolge der Coulomb-Abstoßung der Elektronen im Strahlengang der elektronenoptischen Säule zwischen Quelle und Probe (lateraler Boersch-Effekt). Die elektromagnetische Wechselwirkung zwischen Elektronen ändert aber nicht nur deren mittleren räumlichen Abstand, sondern auch die Breite ihrer Energieverteilung. Eine Verbreiterung der Energieverteilung führt aber indirekt über den Farbfehler der Objektivlinse zu einem größeren Sondendurchmesser. Diesen Beitrag des energetischen Boersch-Effekts zum Sondendurchmesser d berücksichtigt man in Gleichung durch den Farbfehlerscheibchen-Durchmesser $d_F$.

Wie in der deutschen Patentanmeldung P 34 29 804.5 vorgeschlagen wurde, verringert sich der laterale Boersch-Effekt, wenn man die Elektronen die elektronenoptische Säule mit hohen Primärenergien von beispielsweise 10 keV durchlaufen läßt und sie anschließend kurz vor Erreichen der Probe auf die gewünschte niedrige Endenergie von beispielsweise 1 keV abbremst. Da sich der Einfluß des lateralen Boersch-Effekts auf den Sondendurchmesser bei höheren Primärenergien verringert, konnte durch diese Maßnahme der auf der Probe verfügbare Strom bei vorgegebenem Sondendurchmesser d deutlich gesteigert werden. Neuere Rechnungen zeigen aber, daß bei hohen Primärenergien im ersten Teil des Strahlenganges die Breite der Energieverteilung der Elektronen zunimmt. Infolge der hohen Stromdichte liefert der erste Strahlüberkreuzungspunkt CR1 (Quellen-crossover) hierbei den wesentlichen Beitrag.

So beträgt beispielsweise in dem Raster-Elektronenmikroskop S150 der Fa. Cambridge Instruments für Strahlströme von I = 250 μA die Halbwertsbreite der Energieverteilung nach Durchlaufen des Strahlüberkreuzungspunktes CR1 etwa 1,1 eV bei Primärelektronen-Energien von 1 keV, während sie sich bei einer Beschleunigung der Elektronen auf zunächst 10 keV und anschließender Abbremsung auf 1 keV auf etwa 2,2 eV vergrößert. Hierdurch erhöht sich aber nach obiger Gleichung der Beitrag des Farbfehlers zum Sondendurchmesser.

Erfindungsgemäß läßt sich der energetische Boersch-Effekt im Strahlerzeuger eines Raster-Elektronenmikroskops erheblich reduzieren, wenn man die Elektronen den ersten Strahlüberkreuzungspunkt CR1 mit niedriger Energie durchlaufen läßt. Da sich der nachteilige Einfluß des energetischen Boersch-Effekts auf den Sondendurchmesser mit sinkender Elektronenenergie deutlich verringert, sollte die Spannungsdifferenz zwischen Kathode K und Absaugelektrode A1 möglichst klein gewählt werden. Diese Spannungsdifferenz darf andererseits einen Mindestwert nicht unterschreiten, da sich ansonsten eine den Strahlstrom begrenzende Elektronenraumladung im Bereich der Kathode K aufbaut. Als optimaler Wert wird eine Spannungsdifferenz von 2 kV zwischen Kathode und Absaugelektrode angesehen. Unter diesen Bedingungen liefert die Kathode K den maximalen Richtstrahlwert und die Elektronenenergie im ersten Strahlüberkreuzungspunkt CR1 ist gleichzeitig niedrig genug, um die Aufweitung des Strahles infolge des energetischen Boersch-Effekts erheblich reduzieren zu können. Durch die Erfindung verringert sich für das Raster-Elektronenmikroskop der Fa. Cambridge Instruments die Breite der Energieverteilung der Elektronen um etwa 30%, wenn eine Absaugspannung von 2 kV, eine Zwischenbeschleunigung der Elektronen auf 10 keV und eine -Elektronen-Endenergie von 1 keV vorgesehen ist.

Die niederenergetischen Elektronen werden anschließend nach Durchlaufen des Quellen-crossover CR1 im Feld zwischen Absaugelektrode A1 und Anode A2 weiter auf hohe Primärenergien, beispielsweise 10 keV, beschleunigt, um den Einfluß des lateralen Boersch-Effekts auf den Sondendurchmesser im nachfolgenden Teil des Strahlenganges zu reduzieren. Wie schon in der deutschen Patentanmeldung vorgeschlagen, bremst man diese hochenergetischen Elektronen dann mit Hilfe einer elektrostatischen Abbremseinrichtung R kurz vor Erreichen der Probe auf die gewünschte Endenergie von beispielsweise 1 keV ab. Da der Einfluß des lateralen Boersch-Effekts mit der Länge des mit niedrigen Energien durchlaufenen Strahlenganges wächst, sollte das Wegstück zwischen Abbremspunkt und Probe möglichst kurz sein. Optimal erscheint deshalb die in Fig.1 dargestellte Anordnung der Abbremseinrichtung R im Bereich der Objektivlinse OB. Der so erreichbare minimale Abstand zwischen Abbremspunkt und Probe PR führt gegenüber dem Stand der Technik zum größtmöglichen Gewinn im Richtstrahlwert.

Je nach Anwendungsgebiet und Aufgabenstellung kann es günstig sein, mehrere Abbremseinrichtungen vorzusehen. Dies hängt u.a. davon ab, wie groß der Arbeitsabstand zwischen Probe und Detektor sein muß, ob das zu untersuchende Objekt durch die hohen Potentiale der Abbremseinrichtungen R in seiner Funktion beeinträchtigt wird oder ob die Abbremseinrichtungen R zugleich auch linsenähnliche Eigenschaften haben oder in eine Magnetlinse integriert werden sollen.

Im einfachsten Fall besteht die Einrichtung R zum Abbremsen der Elektronen aus einer oder mehreren mit Spannungen beaufschlagten Elektroden. Besonders vorteilhaft sind Netz-bzw. Gitterelektroden, die in erster Näherung keine Linsenwirkung zeigen, falls die das Netz bzw. Gitter bildenden Elemente keine großen Abstände voneinander aufweisen. Komplizierte Potentialverteilungen im Strahlengang sind vermeidbar, wenn man zwei Netzelektroden unmittelbar hintereinander anordnet und die in Strahlrichtung letzte Elektrode als retardierende Elektrode einsetzt. Es kann jedoch auch eine einzelne Netzelektrode verwendet werden, sofern deren komplexe Potentialverteilung bei der Ausgestaltung der übrigen elektronenoptischen Komponenten mit berücksichtigt wird. Grundsätzlich kann mit jedem elektrostatischen Verzögerungselement, insbesondere Zwei- oder Mehr-Elektrodenanordnungen, zum Abbremsen der Elektronen gearbeitet werden.

Als Abbremseinrichtung R mit Linsenwirkung sind Blenden, Zylinderlinsen, Bremslinsen (Einzellinsen) oder Kombinationen daraus auch in Verbindung mit Netz-oder Gitterelektroden verwendbar. Elektrostatische Linsen können hierbei zusätzlich zu oder anstelle von magnetischen Linsen vorgesehen sein. Vorteilhaft ist eine elektronenoptische Kombination einer elektrostatischen Linse mit einer magnetischen Objektivlinse, beispielsweise in Form einer elektrostatischen Immersions-Objektivlinse.

Mit den in Fig.1 bis 5 dargestellten Anordnungen können im ersten niederenergetischen Teilstück des Strahlenganges die nachteiligen Wirkungen des energetischen Boersch-Effekts, im zweiten hochenergetischen Teilstück die Wirkungen des lateralen Boersch-Effekts wesentlich reduziert werden.

Legt man die in Fig.1 angegebenen Spannungen an Kathode K, Wehnelt-Elektrode W, Absaugelektrode ·A1, Anode A2 und Bremseinrichtungen R an, durchlaufen die Elektronen den ersten Strahlüberkreuzungspunkt CR1 mit einer Energie von 2 keV und werden anschließend auf etwa 10 keV weiter beschleunigt. Mit dieser hohen Primärenergie durchlaufen die Elektronen dann die elektronenoptische Säule, um kurz vor Erreichen der auf Erdpotential liegenden Probe PR mit Hilfe einer Elektrodenanordnung R auch die gewünschte Endenergie von 1 keV abgebremst zu werden.

Soll die elektronenoptische Säule mit höheren Primärenergien durchlaufen werden, erhöht man nur die Spannungsdifferenz zwischen Kathode und Anode, ohne die Spannungsdifferenz zwischen Kathode und Absaugelektrode zu verändern.

Zur besseren Definition der Elektronenenergien im hochenergetischen Teil des Strahlenganges führt man die Elektronen vorteilhafterweise bis unmittelbar vor der Abbremselektrode R in einem auf Anodenpotential liegenden Hohlzylinder aus nicht-ferromagnetischem Material.

Die Erfindung kann sinngemäß auch für Elektronenstrahlschreiber übernommen werden, bei denen der Boersch-Effekt ebenfalls die Auflösung begrenzt. Da hier mit höheren Elektronenenergien gearbeitet wird, muß man die Elektronen zunächst mit einer Spannung von etwa 5 kV von der Kathode absaugen, sie dann auf etwa 50 kV beschleunigen und anschließend auf die gewünschte Endenergie von beispielsweise 20 keV abbremsen.

Es sei an dieser Stelle darauf hingewiesen, daß die Erfindung sich auch auf Ionenstrahl-Geräte übertragen läßt.

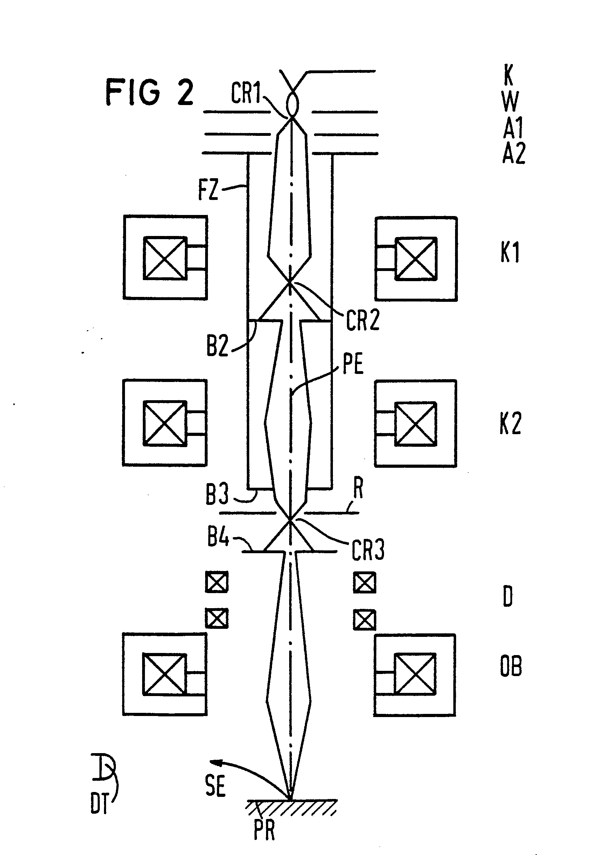

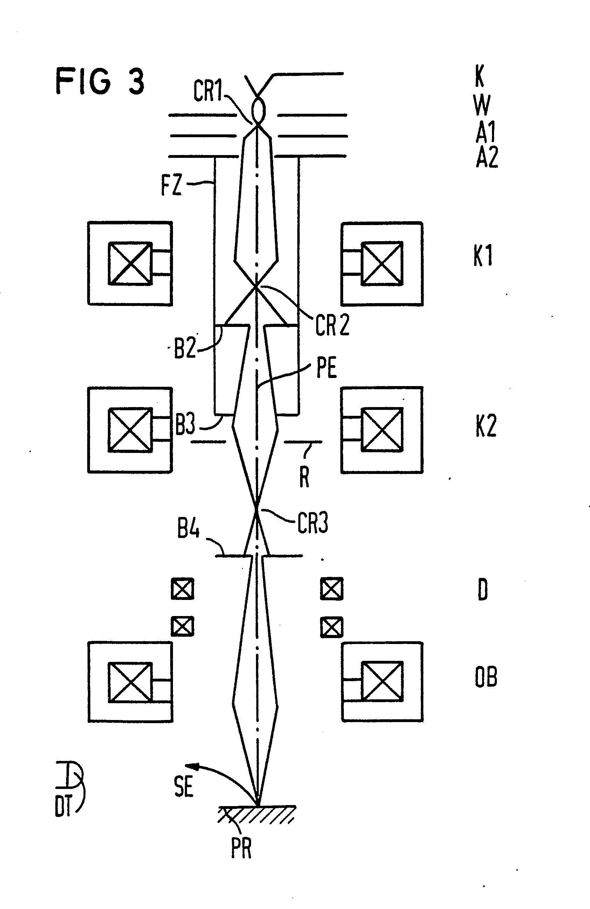

Im Raster-Elektronenmikroskop nach Fig.2 erfolgt die Abbremsung der Primärelektronen auf die gewünschte Endenergie zwischen der Kondensorlinse K2 und der Objektivlinse OB. Ist das Raster-Elektronenmikroskop nur mit einer Kondensorlinse ausgestattet, so wird in einem analogen Ausführungsbeispiel die Abbremselektrode R zwischen dieser Kondensorlinse und der Objektivlinse OB angeordnet. Die Abbremselektrode R kann aber auch -wie in Fig.3 dargestellt -in eine der Kondensorlinsen K2, K3 integriert sein.

Die Ausführungsbeispiele nach Fig.2 und 3 haben den Vorteil, daß ein auf Erdpotential liegender Strahlüberkreuzungspunkt CR3 zugänglich ist. Im Bereich dieser Punkte kann vorteilhafterweise ein Strahlaustastsystem installiert werden.

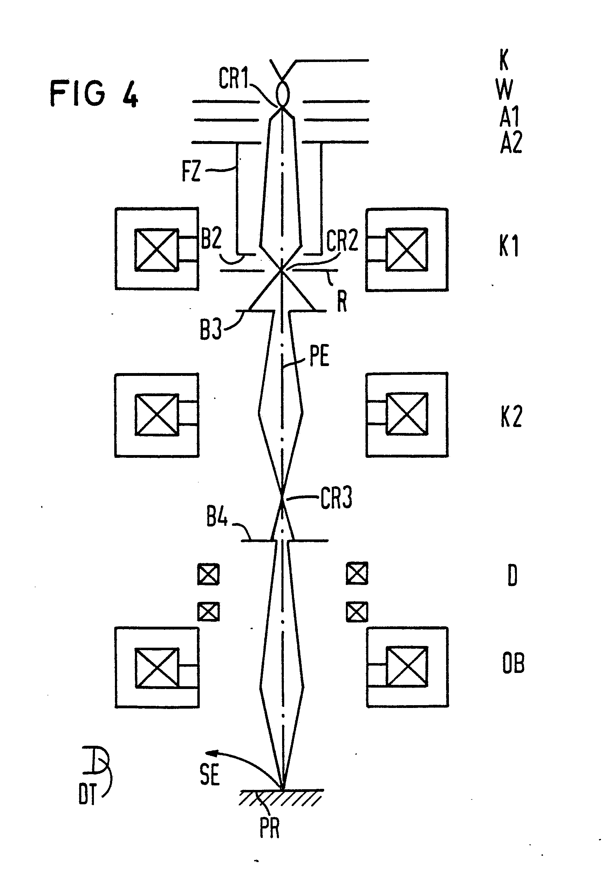

Im Raster-Elektronenmikroskop nach Fig.4 werden die Elektronen zwischen den Kondensorlinsen K1 und K2 abgebremst. Die Abbremselektrode R ist hierbei im Strahlüberkreuzungspunkt CR2 der Kondensorlinse K1 angeordnet.

Weist ein Raster-Elektronenmikroskop mehr als zwei Kondensorlinsen auf, so können die Abbremselektroden analog zu den Ausführungsbeispielen nach Fig.1 bis 4 zwischen zwei aufeinanderfolgenden Kondensorlinsen, innerhalb einer Kondensorlinse bzw. innerhalb oder in Strahlrichtung hinter der Objektivlinse angeordnet werden. Bei Raster-Elektronenmikroskopen mit einer Feldemissions-Kathode erfolgt die Abbremsung der Primärelektronen vorteilhafterweise in Strahlrichtung vor der Objektivlinse OB.

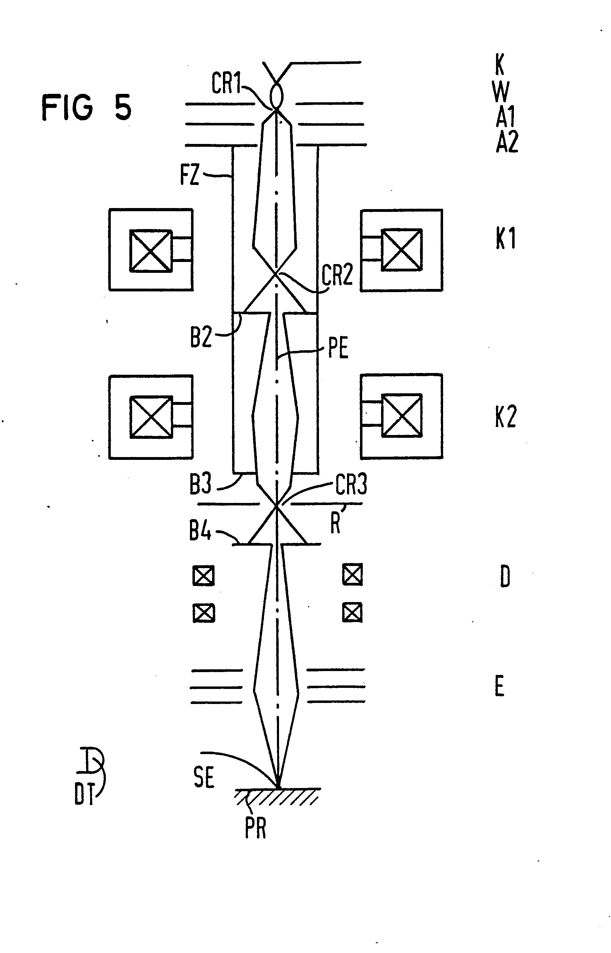

In dem Raster-Elektronenmikroskop nach Fig.5 wurde die Objektivlinse OB durch eine elektrostatische Immersionslinse B ersetzt. Wie aus der US-Patentschrift 4 439 685 bekannt ist, kann eine solche fokussierende Einzellinse derart ausgestaltet werden, daß sie gleichzeitig auch als Strahlaustastsystem einsetzbar ist.

Mit der Verschiebung des Abbremspunktes in Richtung Elektronenquelle verlängert sich der Teil des Strahlenganges, den die Elektronen mit einer niedrigen Endenergie durchlaufen. Zwar wird bei den Anordnungen nach Fig.2 bis 5 weiterhin der nachteilige Einfluß des energetischen Boersch-Effekts im Strahlerzeuger reduziert, die Aufweitung der Elektronensonde infolge des lateralen Boersch-Effekts auf den gesamten Strahlgang nimmt aber proportional dem Abstand zwischen Abbremspunkt und Probe zu. Trotz dieser Nachteile gegenüber der Anordnung nach Fig.1 kann die Stromdichte bei vorgegebenem Sondendurchmesser gegenüber dem Stand der Technik wesentlich gesteigert werden.

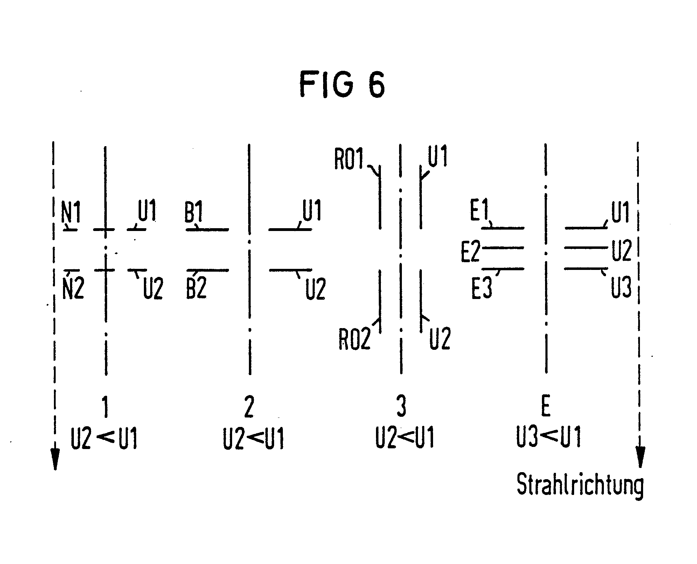

Verschiedene Beispiele für Einrichtungen R zum Abbremsen der hochenergetischen Primärelektronen auf die gewünschte Endenergie zeigt Fig.6. Es kann grundsätzlich jede elektrostatische Verzögerungseinrichtung, insbesondere Zwei-oder Mehr-Elektrodenanordnung oder Kombinationen daraus verwendet werden.

In der aus zwei hintereinandergeschalteten Netzelektroden N aufgebauten Anordnung 1 liegt das der Probe nächstgelegene Netz N2 auf einem niedrigerem Potential als das Netz N1.

Linsenähnliche Eigenschaften besitzt die aus den Blenden B1 und B2 aufgebaute Elektrodenanordnung 2.

Weiter kann eine aus zwei Hohlzylindern RO1 bzw. RO2 aufgebaute Elektrodenanordnung 3 eingesetzt werden. Entsprechend den Elektrodenanordnungen 1 und 2 liegt der Hohlzylinder RO2 auf einem kleineren Potential als Hohzylinder RO1.

Verwendet man zum Abbremsen der Primärelektroden eine elektrostatische Einzellinse E, muß an der Elektrode E3 eine kleinere Spannung anliegen als an der Elektrode E1. Zum Austasten des Elektronenstrahles wird an die mittlere Elektrode E2 ein gegenüber dem Potential U1 sehr stark negatives Potential U2 angelegt.

Die Erfindung wurde bisher am Beispiel eines Raster-Elektronenmikroskopes erläutert. Es sei an dieser Stelle darauf hingewiesen, daß die Erfindung sinngemäß auf alle Korpuskularstrahl-Meßgeräte, insbesondere Ionenstrahl-Meßgeräte, übertragbar ist, deren Auflösung durch den Boersch-Effekt beschränkt wird.

**Ansprüche**

1. Raster-Korpuskularmikroskop

-mit einem Korpuskularstrahl-Erzeuger und einer im Korpuskularstrahl-Erzeuger zwischen Wehnelt-Elektrode und Anode angeordneten Absaugelektrode,

-mit einem strahlformenden Linsensystem,

-mit Einrichtungen zur Fokussierung und Ablenkung des Korpuskularstrahles auf eine Probe und

-mit wenigstens einer Einrichtung zum Abbremsen der Primärkorpuskeln im Korpuskularstrahlengang,

dadurch **gekennzeichnet,**

-daß an der zwischen Wehnelt-Elektrode (W) und Anode - (A2) angeordneten Absaugelektrode (A1) ein bezüglich des Potentials der Kathode (K) positives erstes Potential anliegt,

-und daß an der Anode (A2) ein bezüglich des Potentials der Kathode (K) zweites positives Potential anliegt, wobei dieses zweite positive Potential höher als das an der Absaugelektrode (A1) anliegende erste positive Potential ist.

2. Raster-Korpuskularmikroskop nach Anspruch 1, dadurch **gekennzeichnet,** daß die Potentialdifferenz zwischen Absaugelektrode (A1) und Anode (A2) ein Vielfaches der Potentialdifferenz zwischen Absaugelektrode (A1) und Kathode (K) beträgt.

3. Raster-Korpuskularmikroskop nach Anspruch 1 oder 2, dadurch **gekennzeichnet,** daß die Einrichtung (R) zum Abbremsen der Korpuskeln (PE) in einer magnetischen Linse (K1, K2, OB) angeordnet ist.

4. Raster-Korpuskularmikroskop nach einem der Ansprüche 1 bis 4, dadurch **gekennzeichnet,** daß die Einrichtung (R) zum Abbremsen der Korpuskeln (PE) in einer elektrostatischen Linse (E) integriert ist.

5. Raster-Korpuskularmikroskop nach einem der Ansprüche 1 bis 4, dadurch **gekennzeichnet,** daß die Einrichtung (R) zum Abbremsen der Korpuskeln (PE) zwischen zwei Linsen (K1, K2, OB, E) angeordnet ist.

6. Raster-Korpuskularmikroskop nach einem der Ansprüche 1 bis 5, dadurch **gekennzeichnet,** daß die Einrichtung (R) zum Abbremsen der Korpuskeln (PE) im Korpuskularstrahlengang hinter der letzten Linse (OB, E) angeordnet ist.

7. Raster-Korpuskularmikroskop nach einem der Ansprüche 1 bis 6, **gekennzeichnet** durch eine Feldemissions-Elektrode (K) im Strahlerzeugersystem und der Einrichtung (R) zum Abbremsen der Korpuskeln (PE), die im Korpuskularstrahlengang vor der Objektivlinse (OB) angeordnet ist.

8. Raster-Korpuskularmikroskop nach einem der Ansprüche 1 bis 7, dadurch **gekennzeichnet,** daß die Einrichtung (R) zum Abbremsen der Korpuskeln (PE) als Zwei-Elektrodenanordnung (1, 2, 3) ausgebildet ist.

9. Raster-Korpuskularmikroskop nach einem der Ansprüche 1 bis 8, dadurch **gekennzeichnet,** daß die Einrichtung (R) zum Abbremsen der Korpuskeln (PE) als Mehr-Elektrodenanordnung (E) ausgebildet ist.

10. Raster-Korpuskularmikroskop nach einem der Ansprüche 1 bis 9, dadurch **gekennzeichnet,** daß die Einrichtung (R) zum Abbremsen der Korpuskeln (PE) als Netzelektrode (N) ausgebildet ist.

11. Raster-Korpuskularmikroskop nach einem der Ansprüche 1 bis 10, dadurch **gekennzeichnet,** daß die Einrichtung (R) zum Abbremsen der Korpuskeln (PE) als Blende (B) ausgebildet ist.

12. Raster-Korpuskularmikroskop nach einem der Ansprüche 1 bis 11, dadurch **gekennzeichnet,** daß die Einrichtung (R) zum Abbremsen der Korpuskeln (PE) als Zylinderlinse (RO) ausgebildet ist.

13. Raster-Korpuskularmikroskop nach einem der Ansprüche 1 bis 12, dadurch **gekennzeichnet,** daß die Einrichtung (R) zum Abbremsen der Korpuskeln (PE) als (E) als Einzellinse (E) ausgebildet ist.

14. Raster-Korpuskularmikroskop nach einem der Ansprüche 1 bis 13, dadurch **gekennzeichnet,** daß die Einrichtung (R) zum Abbremsen der Korpuskeln (PE) als elektrostatische Immersionslinse (E) ausgebildet ist.

FIG 1

U    E

K        -1  kV     0 keV
W        ~ -1,5 kV
CR1      +1  kV     2 keV
A1
A2       +9  kV     10 keV
FZ

K1

CR2
B2
PE

K2                  10 keV

CR3
B3

D

OB

B4                  10 keV
SE        0 kV      1 keV
R
DT        0 kV      1 keV
PR

FIG 2

# FIG 3

CR1

K
W
A1
A2

FZ

K1

CR 2

B2

PE

B3

K2

R

CR3

B4

D

OB

DT

SE

PR

FIG 4

CR1

K
W
A1
A2

FZ

B2
CR2
K1

R
B3

PE

K2

CR3
B4

D

OB

SE
DT

PR

FIG 5

CR1

K
W
A1
A2

FZ

K1

CR2

B2

PE

K2

B3 — CR3

B4 — R

D

E

SE

PR

DT

FIG 6